(19) Europäisches Patentamt
European Patent Office
Office européen des brevets

(11) **EP 2 965 106 B1**

(12) **FASCICULE DE BREVET EUROPEEN**

(45) Date de publication et mention de la délivrance du brevet:
**14.08.2019 Bulletin 2019/33**

(51) Int Cl.:
***G01R 33/10*** *(2006.01)* ***G01R 33/00*** *(2006.01)*
***G01R 33/02*** *(2006.01)*

(21) Numéro de dépôt: **14706651.8**

(22) Date de dépôt: **26.02.2014**

(86) Numéro de dépôt international:
**PCT/EP2014/053773**

(87) Numéro de publication internationale:
**WO 2014/135421 (12.09.2014 Gazette 2014/37)**

(54) **PROCEDE DE RECONNAISSANCE AUTOMATIQUE D'UN OBJET MAGNETIQUE**

VERFAHREN ZUR AUTOMATISCHEN ERKENNUNG EINES MAGNETISCHEN OBJEKTS

METHOD FOR AUTOMATICALLY RECOGNISING A MAGNETIC OBJECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.03.2013 FR 1352129**

(43) Date de publication de la demande:
**13.01.2016 Bulletin 2016/02**

(73) Titulaire: **Commissariat à l'Energie Atomique et aux Energies Alternatives
75015 Paris (FR)**

(72) Inventeurs:
• **HAUTSON, Tristan
F-38600 Fontaine (FR)**
• **ALOUI, Rabeb
F-38600 Fontaine (FR)**
• **ALOUI, Saifeddine
F-38000 Grenoble (FR)**
• **JOBERT, Timothée
F-38000 Grenoble (FR)**

(74) Mandataire: **Colombo, Michel
GIE Innovation Competence Group
310 bis Avenue Berthelot
69008 Lyon (FR)**

(56) Documents cités:
**FR-A1- 2 952 450 US-B1- 6 841 994**

EP 2 965 106 B1

**Description**

L'invention concerne un procédé et un appareil de reconnaissance automatique d'un objet magnétique. L'invention concerne également un support d'enregistrement d'informations pour la mise en oeuvre de ce procédé.

Ici, par « objet magnétique », on désigne un objet comportant une ou plusieurs pièces magnétiques réalisées dans un matériau magnétique. Une même pièce magnétique est généralement un seul bloc de matériau magnétique. Un matériau magnétique est un matériau qui présente des propriétés magnétiques mesurables par un appareil de reconnaissance automatique d'objet magnétique.

Il existe de nombreuses situations où il est souhaitable de pouvoir reconnaître automatiquement un objet. Par exemple, cela peut être utile pour modifier le fonctionnement d'une machine, tel qu'un robot, ou pour déclencher automatiquement une action en fonction de l'objet reconnu. Par ailleurs, un grand nombre d'objets comporte déjà des pièces magnétiques. Il est aussi très facile d'ajouter une pièce magnétique, comme par exemple un aimant permanent, à n'importe quel objet.

De l'état de la technique est connu de US6841994B1 et FR2952450A1.

L'invention a donc pour objet un procédé de reconnaissance automatique d'un objet magnétique conforme à la revendication 1.

L'utilisation d'un réseau de magnétomètres séparés les uns des autres par une distance inférieure à l'écartement maximal entre les parties magnétiques de l'objet magnétique les plus éloignées permet de mesurer une signature magnétique très précise de cet objet. Ce procédé est alors particulièrement efficace pour reconnaître l'objet magnétique car il permet de distinguer des objets magnétiques qui se ressemblent. Par exemple, des résultats expérimentaux montrent que ce procédé permet de reconnaître et de distinguer un téléphone iPhone5® d'un téléphone iPhone4® sans apporter aucune modification à ces téléphones portables.

Les modes de réalisation de ce procédé peuvent comporter une ou plusieurs des caractéristiques des revendications dépendantes.

Ces modes de réalisation du procédé présentent en outre les avantages suivants :

- le maintien de l'objet magnétique à une distance inférieure à la distance $d_{max}$ définie ci-dessus et, de préférence inférieure à 50 cm, permet d'améliorer très nettement la reconnaissance de l'objet magnétique ;
- la rotation ou la translation de la signature $S_m$ ou $S_{Ref}$ pour trouver la valeur minimale de l'écart E permet de rendre le procédé de reconnaissance plus robuste vis-à-vis d'erreurs de positionnement de l'objet magnétique à reconnaître par rapport à la position prédéterminée dans laquelle la signature de l'objet connu a été enregistrée ;
- utiliser un réseau de magnétomètres dans lequel la distance fixe entre deux magnétomètres immédiatement consécutifs est inférieure à l'écartement maximal entre les deux parties magnétiques les plus éloignées de l'objet magnétique permet d'améliorer encore plus la précision de la mesure lors de l'étape c) et donc la reconnaissance de l'objet magnétique ;
- utiliser un réseau de magnétomètres dans lequel les magnétomètres sont répartis le long d'au moins deux directions non parallèles permet d'améliorer la reconnaissance des objets magnétiques.

L'invention a également pour objet un support d'enregistrement d'informations conforme à la revendication 8.

L'invention a également pour objet un appareil de reconnaissance d'un objet magnétique conforme à la revendication 9.

L'invention sera mieux comprise à la lecture de la description qui va suivre, donnée uniquement à titre d'exemple non limitatif et faîte en se référant aux dessins sur lesquels :

- la figure 1 est une illustration schématique d'un système d'identification comportant un objet à reconnaître et un appareil de reconnaissance automatique d'objets magnétiques ;
- la figure 2 est une illustration schématique et partielle d'un réseau de magnétomètres utilisé dans l'appareil de reconnaissance du système de la figure 1 ;
- la figure 3 est une illustration schématique d'une base de données utilisée dans l'appareil de reconnaissance du système de la figure 1 ;
- la figure 4 est un organigramme d'un procédé de reconnaissance automatique d'un objet magnétique à l'aide du système de la figure 1.

Dans ces figures, les mêmes références sont utilisées pour désigner les mêmes éléments.

Dans la suite de cette description, les caractéristiques et les fonctions bien connues de l'homme du métier ne sont pas décrites en détail.

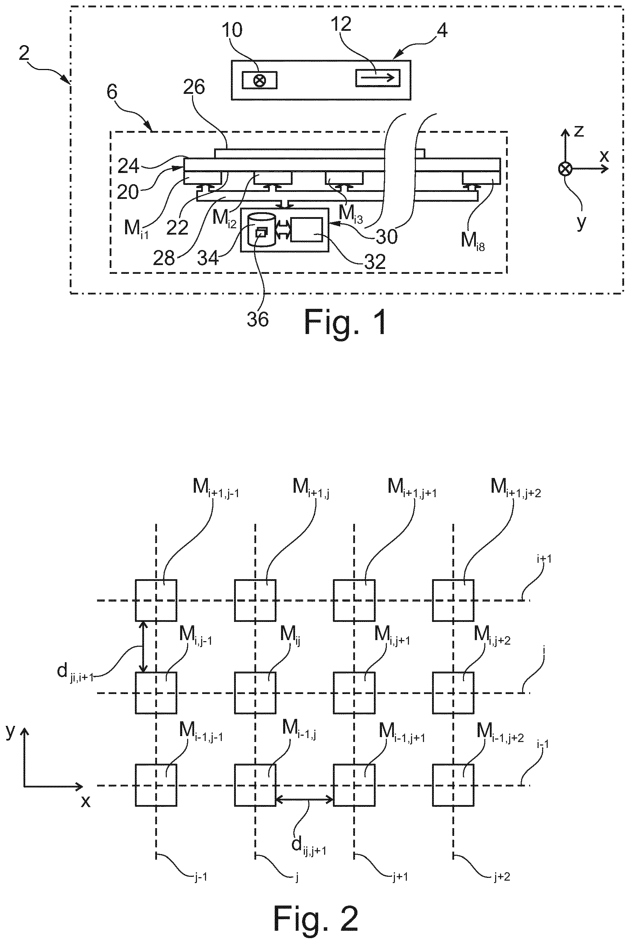

La figure 1 représente un système 2 d'identification. Le système 2 comporte un objet magnétique 4 à reconnaître et un appareil 6 de reconnaissance automatique d'objets magnétiques.

Typiquement, l'objet 4 est déplaçable directement par la main d'un être humain. A cet effet, l'objet 4 pèse généralement moins de 10 kg et, de préférence, moins de 1 kg ou 250 g. Par exemple, les dimensions de l'objet 4 sont suffisamment réduites pour qu'il puisse être saisi et déplacé par une seule main d'un utilisateur.

L'objet 4 comporte au moins une pièce magnétique, c'est-à-dire réalisée dans un matériau magnétique. Cette pièce magnétique est capable de déformer les lignes de champ du champ magnétique terrestre. Ici, le matériau magnétique a une perméabilité relative statique $\mu_r$ différente de un. De préférence, il s'agit d'un matériau ferromagnétique ou ferrimagnétique.

Un objet magnétique peut comporter une seule pièce magnétique ou, au contraire, plusieurs pièces magnétiques distinctes solidaires les unes des autres. Les différentes pièces magnétiques peuvent être mécaniquement fixées les unes aux autres sans aucun degré de liberté ou, au contraire, avec un ou plusieurs degrés de liberté. Chacune de ces pièces magnétiques peut acquérir une aimantation, et donc présenter un moment magnétique non nul, uniquement en présence d'un champ magnétique extérieur tel que le champ magnétique terrestre ou, au contraire, présenter une aimantation permanente. Une pièce magnétique aimantée de façon permanente est aussi appelée un aimant permanent. Un aimant permanent présente un moment magnétique non nul même en absence de champ magnétique extérieur. Typiquement, l'aimant permanent est réalisé dans un matériau magnétique dont le champ magnétique coercitif est supérieur à 100 A.m$^{-1}$ ou à 500 A.m$^{-1}$. La puissance de cet aimant permanent peut être supérieure à 0,01A.m$^2$ ou 0,1A.m$^2$. Lorsque l'objet magnétique comporte plusieurs aimants permanents, il est également préférable que le rapport entre les puissances de ces aimants permanents soit inférieur à dix ou cinq et, avantageusement, inférieur à deux ou 1,5 ou égal à un.

Ici, l'objet 4 comporte essentiellement deux pièces magnétiques 10 et 12 immobiles l'une par rapport à l'autre. Par exemple, elles sont fixées sans aucun degré de liberté à un même châssis de l'objet 4. Ici, ce châssis est en matériau non-magnétique. Un matériau non-magnétique ne présente pas de propriété magnétique mesurable par l'appareil 6.

Étant donné que les pièces magnétiques 10 et 12 sont fixes dans l'objet 4, les distances relatives entre les dipôles magnétiques correspondant aux pièces 10 et 12 ainsi que les angles entre ces moments magnétiques sont constants. De même, dans ce mode de réalisation, le nombre de pièces magnétiques à l'intérieur de l'objet 4 et les moments magnétiques de ces pièces sont supposés constant.

Ici, l'objet 4 est un téléphone portable. Dans le cas d'un téléphone portable, les deux pièces magnétiques 10 et 12 sont formées, respectivement, par le microphone et le haut-parleur du téléphone. En effet, ces pièces comportent des aimants permanents.

L'appareil 6 permet de mesurer le champ magnétique terrestre déformé par la présence de l'objet 4. A cet effet, l'appareil 6 comporte un réseau de N magnétomètres tri-axes $M_{ij}$. Sur la figure 1, les traits ondulés verticaux indiquent qu'une partie de l'appareil 6 n'a pas été représentée.

Typiquement, N est supérieur à cinq et, de préférence, supérieur à seize ou trente-deux. Ici, N est supérieur ou égal à soixante-quatre.

Dans ce mode de réalisation, les magnétomètres $M_{ij}$ sont alignés en lignes et en colonnes pour former une matrice. Ici, cette matrice comporte huit lignes et huit colonnes. Les indices i et j identifient, respectivement, la ligne et la colonne de cette matrice à l'intersection de laquelle se trouve le magnétomètre $M_{ij}$. Sur la figure 1, seuls les magnétomètres $M_{i1}$, $M_{i2}$, $M_{i3}$, $M_{i4}$ et $M_{i8}$ d'une ligne i sont visibles. La position des magnétomètres $M_{ij}$ les uns par rapport aux autres est décrite plus en détail en référence à la figure 2.

Chaque magnétomètre $M_{ij}$ est fixé sans aucun degré de liberté aux autres magnétomètres. A cet effet, les magnétomètres $M_{ij}$ sont fixés sans aucun degré de liberté sur une face arrière 22 d'une plaque rigide 20 horizontale. Cette plaque rigide présente une face avant 24 tournée vers l'objet 4. La plaque 20 est réalisée dans un matériau non magnétique rigide. Par exemple, la plaque 20 est en verre.

De préférence la plaque 20 comporte aussi sur sa face avant un dispositif 26 d'aide au placement de l'objet 4. Ce dispositif 26 aide l'utilisateur à positionner et à maintenir l'objet 4 dans une position prédéterminée par rapport aux magnétomètres $M_{ij}$. Le dispositif 26 est par exemple un gabarit de l'objet. Ce gabarit comporte un dessin sur la face 24 du pourtour de l'objet 4 ou une empreinte en creux de l'objet 4.

Chaque magnétomètre $M_{ij}$ mesure la direction et l'amplitude du champ magnétique généré ou perturbé par l'objet 4. Pour cela, chaque magnétomètre $M_{ij}$ mesure la norme de la projection orthogonale du champ magnétique au niveau de ce magnétomètre $M_{ij}$ sur trois axes de mesure de ce magnétomètre. Ici, ces trois axes de mesure sont orthogonaux entre eux. Par exemple, les axes de mesure de chacun des magnétomètres $M_{ij}$ sont, respectivement, parallèles aux directions X, Y et Z d'un repère orthogonal XYZ. Le repère XYZ est fixé sans aucun degré de liberté à l'appareil 6. Ici, les directions X et Y sont horizontales et la direction Z est verticale. Ici, on note $b_{ij}$ le vecteur dont les coordonnées sont formées par les mesures $x_{ij}$, $y_{ij}$ et $z_{ij}$, où $x_{ij}$, $y_{ij}$ et $z_{ij}$ sont les mesures du magnétomètre $M_{ij}$ sur ses axes de mesure parallèles, respectivement, aux directions X, Y et Z

La sensibilité du magnétomètre $M_{ij}$ est par exemple égale ou inférieure à 4*10$^{-7}$T.

Chaque magnétomètre $M_{ij}$ est raccordé par l'intermédiaire d'un bus 28 de transmission d'informations à une unité de traitement 30.

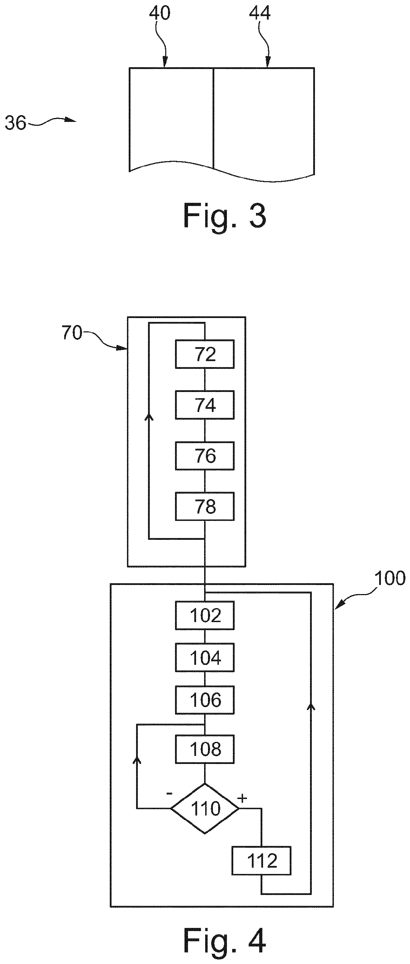

L'unité de traitement 30 est apte à mettre en oeuvre le procédé de la figure 4. En particulier, à partir des mesures des magnétomètres $M_{ij}$, l'unité 30 est capable de reconnaître l'objet magnétique présenté devant l'appareil 6 par comparaison à une base de données 36 de signatures magnétiques d'objets connus. Cette base de données 36 est décrite plus en détail en référence à la figure 3. A cet effet, l'unité 30 comporte un calculateur électronique 32 programmable apte à exécuter des instructions enregistrées sur un support d'enregistrement d'informations. L'unité 30 comporte donc aussi une mémoire 34 contenant les instructions nécessaires pour l'exécution par le calculateur 32 du procédé de la figure 4. La base de données 36 est enregistrée dans la mémoire 34.

La figure 2 représente une partie des magnétomètres $M_{ij}$ de l'appareil 6. Ces magnétomètres $M_{ij}$ sont alignés en lignes i parallèles à la direction X. Ces magnétomètres sont également alignés en colonnes j parallèles à la direction Y pour former une matrice. Les lignes i et les colonnes j sont disposées dans l'ordre des indices croissants.

La surface occupée par le réseau de magnétomètres est typiquement inférieure à 100 m$^2$ et, de préférence, inférieure à 5 m$^2$ ou 1 m$^2$ ou 50 cm$^2$.

Le centre du magnétomètre $M_{ij}$ se trouve à l'intersection de la ligne i et de la colonne j. Le centre du magnétomètre correspond au point où le champ magnétique est mesuré par ce magnétomètre. Ici, les indices i et j appartiennent à l'intervalle [1 ; 8].

Les centres de deux magnétomètres $M_{ij}$ et $M_{i,j+1}$ immédiatement consécutifs le long d'une ligne i sont séparés par une distance connue $d_{i,j,j+1}$. De façon similaire, le centre de deux magnétomètres $M_{ij}$ et $M_{i+1,j}$ immédiatement consécutifs le long d'une même colonne j sont séparés par une distance connue $d_{j,i,i+1}$.

Dans le cas particulier décrit ici, quelle que soit la ligne i, la distance $d_{i,j,j+1}$ est la même. Cette distance est donc notée $d_j$. De façon similaire, quelle que soit la colonne j, la distance $d_{j,i,i+1}$ entre deux magnétomètres est la même. Cette distance est donc notée $d_i$.

Ici, les distances $d_i$ et $d_j$ sont toutes les deux égales à d.

La distance d est inférieure à, et de préférence au moins deux fois plus petite que, l'écartement maximal entre les parties magnétiques de l'objet magnétique à reconnaître les plus éloignées l'une de l'autre. Ici, cette distance d est donc inférieure à la distance la plus courte qui sépare les pièces 10 et 12.

Typiquement, la distance d est comprise entre 1 et 4 cm lorsque :

- la puissance de chaque aimant permanent susceptible d'être contenu dans l'objet à reconnaître est inférieure de 2 A.m$^2$ ou 1 A.m$^2$ ou 0,5 A.m$^2$ et, de préférence, supérieure à 0,1 A.m$^2$ ou 0,2 A.m$^2$,
- la sensibilité des magnétomètres est de $4*10^{-7}$T, et
- le nombre de magnétomètres $M_{ij}$ est de soixante-quatre.

La figure 3 représente plus en détail la base de données 36. Cette base de données 36 contient les signatures magnétiques de plusieurs objets magnétiques connus. Ici, elle est représentée sous la forme d'une table.

Pour chaque objet connu, la base de données 36 comporte, dans une colonne 40, un identifiant « Ref » de cet objet connu. L'identifiant « Ref » identifie de façon unique cet objet connu parmi l'ensemble des objets connus enregistrés dans la base de données 36. Chaque identifiant « Ref » est associé par la base 36 à une signature magnétique préenregistrée $S_{Ref}$ de cet objet connu. La signature $S_{Ref}$ est contenue dans la colonne 44.

La signature magnétique d'un objet comporte des caractéristiques distinctives permettant d'identifier cet objet parmi l'ensemble des objets connus répertoriés dans la base de données 36. Ici, elle comporte la réunion des vecteurs $b_{ij}$ mesurés en même temps par chacun des magnétomètres $M_{ij}$. Une signature magnétique d'un objet est donc l'ensemble des vecteurs : $\{b_{11}, b_{12}, ... , b_{ij}, b_{i,j+1}, ..., b_{i+1,j}, b_{i+1,j+1}, ..., b_{N,N}\}$. Par la suite pour distinguer les vecteurs et les mesures contenus dans la signature d'un objet connu « Ref » de ceux contenus dans la signature d'un objet à reconnaître, on fait suivre, de l'indice « Ref », l'identifiant « ij » du magnétomètre $M_{ij}$ dans le cas des vecteurs et mesures contenus dans la signature $S_{Ref}$. A l'inverse, on fait suivre par l'indice « m », l'identifiant « ij » du magnétomètre $M_{ij}$ dans le cas des vecteurs et mesures contenus dans la signature $S_m$ de l'objet à reconnaître. Ainsi, avec ces notations, le vecteur $b_{ij,Ref}$ et la mesures $x_{ij,ref}$ désignent, respectivement, le vecteur $b_{ij}$ et la mesure $x_{ij}$ obtenus à partir du magnétomètre $M_{ij}$ et contenus dans la signature $S_{Ref}$. Le vecteur $b_{ij,m}$ et la mesure $x_{ij,m}$ désignent, respectivement, le vecteur $b_{ij}$ et la mesure $x_{ij}$ obtenus à partir du magnétomètre $M_{ij}$ et contenus dans la signature $S_m$.

Le fonctionnement du système 2 va maintenant être décrit en référence au procédé de la figure 4.

Ce procédé débute par une phase 70 d'enregistrement de signatures magnétiques $S_{Ref}$ de plusieurs objets magnétiques connus dans la base de données 36 et d'association à chacune de ces signatures d'un identifiant d'objet connu.

Pour cela, par exemple, lors d'une étape 72, on place l'objet connu devant la face 24 dans une position prédéterminée et on le maintient immobile dans cette position pendant toute la durée de l'étape suivante. La position prédéterminée est choisi de manière à ce que, dans celle-ci, la distance la plus courte entre au moins quatre des magnétomètres $M_{ij}$ et l'objet connu soit inférieure à $d_{max}$. $d_{max}$ est égal à $[\mu_0 m/4\pi\sigma 10^{(SNR/20)}]^{1/3}$, où :

- $\sigma$ est l'écart-type du bruit des magnétomètres,
- $\mu_0$ est la perméabilité du vide,
- m est le moment magnétique de l'objet magnétique, et
- SNR est une constante égale à 6,02 db.

Typiquement, pour les objets que l'on cherche à reconnaître, $d_{max}$ est égal ou plus petit que 50 cm ou 30 cm.

A cet effet, l'objet connu est posé à l'intérieur du gabarit du dispositif 26. Par exemple, il est maintenu immobile à l'intérieur de ce gabarit par la seule force de gravité.

Ensuite, lors d'une étape 74, les magnétomètres $M_{ij}$ mesurent simultanément le champ magnétique en présence de l'objet connu. De préférence, l'étape 74 est réitérée plusieurs fois, par exemple plus de dix ou cinquante fois, pour obtenir plusieurs mesures pour chaque magnétomètre $M_{ij}$. Ensuite, c'est la moyenne de ces mesures pour chaque magnétomètre $M_{ij}$ qui est traitée lors des étapes suivantes. Cela permet de filtrer une partie du bruit des mesures. L'étape 74 dure typiquement moins d'une seconde.

Lors d'une étape 76, l'unité 30 construit la signature magnétique $S_{Ref}$ de l'objet connu à partir des mesures réalisées lors de l'étape 74. Cette signature $S_{Ref}$ comporte notamment la réunion des vecteurs $b_{ij,Ref}$ mesurés lors de l'étape 74 par tous les magnétomètres Mij.

Lors d'une étape 78, la signature $S_{Ref}$ est enregistrée dans la base de données 36 associée à l'identifiant « Ref » de l'objet connu.

Les étapes 72 à 78 sont ensuite réitérées pour un grand nombre d'objets connus différents les uns des autres afin de peupler la base de données 36. Les étapes 72 à 78 peuvent aussi être réitérées pour le même objet connu mais placé dans une position différente vis-à-vis des magnétomètres $M_{ij}$. En effet, la présence du dispositif 26 limite le nombre de positions possibles de l'objet par rapport aux magnétomètres $M_{ij}$ mais n'interdit pas nécessairement plusieurs positions prédéterminées pour le même objet. Par exemple, dans le cas d'un téléphone portable celui-ci peut être disposé à l'intérieur du gabarit avec son écran tourné vers la face 24 ou tournée à l'opposé de la face 24. Il peut aussi être disposé à l'intérieur du gabarit avec son microphone situé à gauche ou à droite. Ainsi, le gabarit autorise quatre positions prédéterminées pour un téléphone portable. Toutefois, il n'est pas systématiquement nécessaire d'enregistrer une signature $S_{Ref}$ pour chaque position prédéterminée possible de l'objet connu. En effet, comme expliqué ci-dessous, il est possible de reconnaître un objet même si celui-ci n'est pas placé exactement dans la même position prédéterminée que celle utilisée pour relever la signature $S_{Ref}$.

A titre d'exemple, les signatures des objets suivants sont enregistrées dans la base de données 36 lors de la phase 70 :

- l'objet 4,
- un téléphone portable d'une autre marque que celle de l'objet 4,
- une agrafeuse,
- un tournevis,
- un stylo équipé d'au moins un aimant permanent,
- un pinceau équipé d'un aimant permanent de puissance supérieure à celle de l'aimant du stylo,
- une ampoule, et
- un ordinateur portable.

Une fois que la base de données 36 a été peuplée de plusieurs signatures magnétiques d'objets connus, on procède alors à une phase 100 de reconnaissance automatique d'un objet inconnu. L'objet inconnu est choisi parmi les objets dont les signatures ont été enregistrées lors de la phase 70. Par la suite, on suppose que cet objet inconnu est l'objet 4.

La phase 100 débute par trois étapes 102 à 106 identiques, respectivement, aux étapes 72 à 76 sauf que c'est l'objet inconnu qui est placé devant la face 24. A l'issue de l'étape 106, c'est donc la signature $S_m$ de l'objet 4 qui est obtenue.

Lors d'une étape 108, l'unité 30 calcule un écart E entre la signature $S_m$ une signature $S_{Ref}$ pré-enregistrée dans la base de données 36. L'écart E est représentatif de la ressemblance entre les signatures $S_m$ et $S_{Ref}$. Ici, plus cette ressemblance est élevée, plus l'écart E est faible.

Dans ce mode de réalisation, les étapes suivantes sont basées sur l'analogie qui existe entre une signature magnétique construite par l'unité 30 et une image matricielle. A cet effet, chaque signature magnétique est enregistrée dans un fichier au format d'une image matricielle. Par exemple, le format utilisé est le format connu sous le terme de « bitmap ». Pour cela, chaque magnétomètre $M_{ij}$ est assimilé à un capteur permettant de mesurer l'équivalent d'une « couleur », la « couleur » étant ici les mesures $x_{ij}$, $y_{ij}$ et $z_{ij}$ du magnétomètre $M_{ij}$. Plus précisément :

- les indices ij qui identifient la position du magnétomètre $M_{ij}$ dans le repère X, Y, Z correspondent à la position du pixel dans l'image, et

- les mesures $x_{ij}$, $y_{ij}$ et $z_{ij}$ du magnétomètre $M_{ij}$ codent la couleur du pixel par exemple, dans un codage RVB (Rouge Vert Bleu).

Ici, chaque couple d'indices « ij » est associé aux coordonnées $a_{ij}$, $b_{ij}$ et $c_{ij}$ du magnétomètre $M_{ij}$ dans le repère XYZ.

Par la suite, chaque fichier contenant une signature magnétique dans un format d'image matricielle est appelé « image magnétique ». Les fichiers contenant les signatures $S_m$ ou $S_{Ref}$ sont désignés, respectivement, par images $I_m$ et $I_{Ref}$. Dans ces fichiers, chaque pixel $P_{ij}$ correspond à un magnétomètre $M_{ij}$ respectif. A partir du moment où les signatures $S_m$ et $S_{Ref}$ sont enregistrées au format d'une image matricielle, il est possible d'utiliser les mêmes algorithmes connus que ceux utilisés en traitement d'images pour calculer la corrélation entre les fichiers $I_m$ et $I_{Ref}$ et donc entre les signatures $S_m$ et $S_{Ref}$, et aussi l'écart minimal E entre ces signatures. Ces algorithmes ne sont donc pas décrits ici en détail.

Par exemple, l'unité 30 applique une transformation à l'image $I_m$ pour obtenir une image transformée $I_t$ qui minimise la valeur de l'écart E. Typiquement, cette transformation est une composition de translations et de rotations. Par exemple, les translations appliquées aux pixels de l'image $I_m$ sont des translations parallèles au plan XY. Les rotations appliquées aux pixels de l'image $I_m$ sont des rotations autour d'un axe parallèle à la direction Z ou des rotations de 180° par rapport à un axe appartenant au plan XY.

L'écart E est par exemple calculé à l'aide de l'une des formules suivantes :

$$(1) \quad E = \sum_{k=1}^{N} \sqrt{(x_{k,m} - x_{k,Ref})^2 + (y_{k,m} - y_{k,Ref})^2 + (z_{k,m} - z_{k,Ref})^2}$$

$$(2) \quad E = \sqrt{\sum_{k=1}^{N} (x_{k,m} - x_{k,Ref})^2 + (y_{k,m} - y_{k,Ref})^2 + (z_{k,m} - z_{k,Ref})^2}$$

$$(3) \quad E = \sum_{k=1}^{N} \left( |x_{k,m} - x_{k,Ref}| + |y_{k,m} - y_{k,Ref}| + |z_{k,m} - z_{k,Ref}| \right)$$

A l'issue de l'étape 108, la valeur de l'écart E est la valeur obtenue avec la transformation de l'image $I_m$ qui minimise cet écart. Le fait d'utiliser un algorithme qui permet de trouver la transformation qui corrèle le mieux les signatures $S_m$ et $S_{Ref}$ rend le procédé de reconnaissance robuste vis-à-vis des erreurs de positionnement de l'objet 4 par rapport à la position prédéterminée où la signature $S_{Ref}$ a été enregistrée.

Ensuite, lors d'une étape 110, l'écart E est comparé à un seuil prédéterminé $L_1$. Si l'écart E est supérieur au seuil $L_1$, les étapes 108 et 110 sont réitérées avec une nouvelle signature $S_{Ref}$. Si par contre, les étapes 108 et 110 ont déjà été exécutées pour toutes les signatures $S_{ref}$ contenues dans la base de données 36, sans que l'objet 4 n'ait pu être reconnu, alors le procédé s'arrête, et l'unité 30 indique que l'objet 4 n'a pas été reconnu.

Si l'erreur E est inférieure au seuil $L_1$, l'objet 4 correspond à l'objet connu « Ref ». En réponse, lors d'une étape 112, l'unité 30 communique cette information à un module logiciel chargé d'exécuter une opération spécifique en réponse à la reconnaissance de l'objet 4. Par exemple, ce module logiciel communique l'identifiant « Ref » de l'objet reconnu à un être humain par l'intermédiaire d'une interface homme-machine. Ce module logiciel peut également déclencher automatiquement une action en réponse à la reconnaissance de cet objet comme, par exemple, la commande d'un périphérique électronique extérieur.

De nombreux autres modes de réalisations sont possibles. Par exemple, les pièces magnétiques de l'objet à reconnaître peuvent participer au fonctionnement de cet objet. C'est par exemple le cas lorsque les pièces magnétiques sont les aimants permanents du haut-parleur et du microphone d'un téléphone portable. Toutefois, les pièces magnétiques peuvent aussi être ajoutées à l'objet à reconnaître en vue de permettre sa reconnaissance par l'appareil 6. Par exemple, des aimants permanents différents sont ajoutés à des ustensiles normalement dépourvus de pièce magnétique, tels qu'un crayon et à un effaceur. Dès lors, l'appareil 6 peut les reconnaître.

Les magnétomètres peuvent avoir plus de trois axes de mesure. Toutefois, même quand un magnétomètre a plus de trois axes de mesure, ce magnétomètre est ici également qualifié de magnétomètre « tri-axe » car il comporte au moins trois axes de mesure non colinéaire.

La distance entre les magnétomètres n'a pas besoin d'être connue. Il suffit qu'elle soit constante pour que la reconnaissance de l'objet magnétique puisse être mise en oeuvre.

Les magnétomètres $M_{ij}$ ne sont pas nécessairement disposés dans un même plan. En variante, les magnétomètres sont disposés dans un espace à trois dimensions. Dans cet espace, la position de chaque magnétomètre est repérée par les coordonnées $a_{ij}$, $b_{ij}$ précédemment définies et en plus par une coordonnée $c_{ij}$ le long de la direction Z du repère X, Y, Z. Dans cette variante, la valeur de la coordonnée $c_{ij}$ n'est pas la même pour tous les magnétomètres. A l'inverse, dans un cas extrêmement simplifié, l'ensemble des magnétomètres du réseau sont alignés le long d'un même axe rectiligne.

En variante, le dispositif 26 d'aide au positionnement de l'objet magnétique à reconnaître est omis. A l'inverse, dans un autre mode de réalisation, ce dispositif 26 peut être remplacé par un dispositif d'aide plus performant, comportant par exemple des détrompeurs mécaniques qui n'autorisent le positionnement de l'objet à reconnaître que dans l'une des positions prédéterminées ou une signature magnétique $S_{Ref}$ du même objet a déjà été préenregistrée dans la base de données 36.

La phase 70 d'enregistrement peut être réalisée différemment. Par exemple, les signatures $S_{Ref}$ sont construites à partir de mesures fournies par un autre appareil que l'appareil 6. Dans ce cas, cet autre appareil comporte la même matrice de magnétomètres $M_{ij}$.

En variante, la signature magnétique d'un objet comporte uniquement les vecteurs $b_{ij}$ dont l'amplitude dépasse un seuil prédéterminé, par exemple, plusieurs fois supérieure au niveau du bruit ambiant.

La signature magnétique d'un objet peut changer en fonction de son état d'utilisation. Par exemple, l'amplitude de l'un des moments magnétiques de l'objet peut varier au cours du temps entre un état dans lequel l'objet 4 est alimenté ou allumé et un état dans lequel l'objet 4 est éteint ou non alimenté. Dans ce cas, une solution consiste à enregistrer dans la base de données 36 une première signature magnétique de l'objet lorsqu'il est allumé et une seconde signature lorsqu'il est éteint. Ainsi, en plus de reconnaître l'objet, cela permet aussi d'indiquer s'il est éteint ou allumé.

Les mesures des magnétomètres peuvent être enregistrées dans un premier temps. Ensuite, les étapes 76, 78 ou 104 à 112 sont réalisées ultérieurement à un moment où l'objet magnétique n'est plus présent devant la face 24 du réseau de magnétomètres. De même l'exécution du procédé de la figure 4 peut être répartie sur plusieurs calculateurs électroniques. Par exemple, les étapes 108 à 112 sont exécutées par un calculateur électronique programmable distinct du calculateur qui exécute seulement les étapes 102 à 106. L'unité 30 de traitement comporte alors l'ensemble de ces calculateurs.

L'étape 108 peut être réalisée différemment. Par exemple, c'est l'image $I_{Ref}$ qui est transformé et non pas l'image $I_m$.

L'étape 108 peut être simplifiée si l'objet magnétique à reconnaître est toujours placé dans l'une des positions prédéterminées où une signature $S_{Ref}$ a été enregistrée dans la base de données 36. Dans ce cas, il est possible de procéder directement au calcul de la valeur de l'écart E à l'aide de l'une des relations (1), (2), ou (3) sans essayer d'ajuster au mieux l'image $I_m$ à l'image $I_{Ref}$.

En variante, un filtrage des résultats de reconnaissance peut être ajouté. Pour cela, la phase 100 est réitérée plusieurs fois pour le même objet à reconnaître. Lors de l'étape 112, l'objet est considéré comme reconnu uniquement si le même objet a été reconnu à l'issue de plus de 50 % ou 80 % des itérations de la phase 100.

La valeur du seuil $L_1$ peut être une constante indépendante des résultats des étapes précédentes, ou au contraire, être prédéterminée en fonction des itérations précédentes des étapes 108 et 110. Par exemple, la valeur du seuil $L_1$ est remplacée par la valeur de l'écart E à chaque fois que la valeur de cet écart est plus petite que celle du seuil $L_1$. Dans ce cas, l'objet qui est reconnu correspond systématiquement à celui pour lequel la valeur de l'écart E est minimale.

**Revendications**

**1.** Procédé de reconnaissance automatique d'un objet magnétique, comportant:

a) le maintien (102) immobile de l'objet magnétique devant un réseau de magnétomètres comportant N magnétomètres tri-axes ($M_{ij}$) reliés mécaniquement les uns aux autres sans aucun degré de liberté pour conserver une distance fixe entre chacun de ces magnétomètres, où N est un nombre entier supérieur ou égal à cinq, la distance fixe entre deux magnétomètres immédiatement consécutifs étant au moins inférieure à l'écartement maximal entre les parties magnétiques de l'objet magnétique les plus éloignées l'une de l'autre,

b) lorsque l'objet magnétique est maintenu immobile devant le réseau de magnétomètres, la mesure (104) par chaque magnétomètre d'un vecteur $b_{i,m}$ dont chaque coordonnée représente la valeur du champ magnétique projeté sur un axe respectif de mesure du magnétomètre, une réunion de vecteurs $b_{i,m}$ mesurés en même temps par les magnétomètres du réseau formant une signature magnétique mesurée $S_m$ de cet objet, où l'indice « i » est un identifiant du magnétomètre, **caractérisé par**

c) le calcul (108) d'un écart E entre la signature magnétique $S_m$ mesurée lors de l'étape b) et une signature magnétique préenregistrée $S_{Ref}$ d'un objet magnétique connu,

d) la comparaison (110) de l'écart E calculé lors de l'étape c) à un seuil prédéterminé et la reconnaissance (112) de l'objet magnétique si l'écart E est inférieur ou égal à ce seuil prédéterminé, et sinon, l'absence de reconnaissance de l'objet magnétique.

2. Procédé selon la revendication 1, dans lequel, lors de l'étape a), pour au moins quatre magnétomètres du réseau de magnétomètres, la distance la plus courte entre ces magnétomètres et l'objet magnétique est inférieure à $d_{max}$, $d_{max}$ étant égal à $[\mu_0 m/4\pi\sigma 10^{(SNR/20)}]^{1/3}$, où :

   - $\sigma$ est l'écart-type du bruit du magnétomètre,
   - $\mu_0$ est la perméabilité du vide,
   - m est le moment magnétique de l'objet magnétique, et
   - SNR est une constante égale à 6,02 db.

3. Procédé selon la revendication 1, dans lequel, lors de l'étape a), pour au moins quatre magnétomètres du réseau de magnétomètres, la distance la plus courte entre ces magnétomètres et l'objet magnétique est inférieure à 50 cm.

4. Procédé selon l'une quelconque des revendications précédentes, dans lequel :

   - le procédé comprend l'association (108) à chaque vecteur $b_{i,m}$ et à chaque vecteur $b_{i,Ref}$ de la signature magnétique préenregistrée, des mêmes coordonnées $a_i$, $b_i$, $c_i$ de la position du magnétomètre « i » dans un repère XYZ fixé sans aucun degré de liberté au réseau de magnétomètres, le vecteur $b_{i,Ref}$ correspondant au vecteur qui serait mesuré lors de l'étape b), par le magnétomètre i, lorsque l'objet connu est maintenu immobile dans la position prédéterminée devant le réseau de magnétomètres, et
   - l'étape c) comporte la transformation de l'une des signatures magnétiques choisie parmi les signatures magnétiques mesurée $S_m$ et préenregistrée $S_{Ref}$ par des translations et/ou des rotations appliquées aux coordonnées $a_i$, $b_i$, $c_i$ associées à chacun des vecteurs $b_{i,m}$ ou $b_{i,Ref}$ de cette signature, pour obtenir une signature magnétique transformée St qui minimise l'écart entre cette signature St et l'autre des signatures magnétiques choisie parmi les signatures magnétiques mesurée $S_m$ et préenregistrée $S_{Ref}$, la valeur de l'écart E calculée à l'issue de l'étape c) étant prise égale à la valeur minimale obtenue après avoir appliqué cette transformation à la signature magnétique $S_m$ ou $S_{ref}$.

5. Procédé selon l'une quelconque des revendications 1 à 3, dans lequel, lors de l'étape c), l'écart E est calculé à partir de la différence, pour chaque magnétomètre, entre les coordonnées du vecteur $b_{i,m}$ et des coordonnées d'un vecteur $b_{i,Ref}$ de la signature magnétique préenregistrée, le vecteur $b_{i,Ref}$ correspondant au vecteur qui serait mesuré lors de l'étape b), par le magnétomètre i, lorsque cet objet connu est maintenu immobile dans la position prédéterminée devant le réseau de magnétomètres.

6. Procédé selon l'une quelconque des revendications précédentes, dans lequel, lors de l'étape a), l'objet magnétique est maintenu (102) dans la position prédéterminée devant un réseau de magnétomètres dans lequel la distance fixe entre deux magnétomètres immédiatement consécutifs est au moins deux fois plus petite que l'écartement maximal entre les deux parties magnétiques de l'objet magnétique les plus éloignées l'une de l'autre.

7. Procédé selon l'une quelconque des revendications précédentes, dans lequel le réseau de magnétomètres comprend des magnétomètres répartis le long d'au moins deux directions non parallèles.

8. Support d'enregistrement d'informations, **caractérisé en ce qu'**il comporte des instructions pour réaliser les étapes c) et d) d'un procédé de reconnaissance conforme à l'une quelconque des revendications précédentes, lorsque ces instructions sont exécutées par un calculateur électronique.

9. Appareil de reconnaissance d'un objet magnétique, cet appareil comporte :

   - un réseau de magnétomètres comportant N magnétomètres tri-axes ($M_{ij}$) reliés mécaniquement les uns aux autres sans aucun degré de liberté pour conserver une distance fixe entre chacun de ces magnétomètres, où N est un nombre entier supérieur ou égal à cinq, chaque magnétomètre étant apte à mesurer un vecteur $b_{i,m}$ dont chaque coordonnée représente la valeur du champ magnétique projetée sur un axe respectif de mesure

EP 2 965 106 B1

du magnétomètre, une réunion de vecteurs $b_{i,m}$ mesurés en même temps par les magnétomètres du réseau, formant une signature magnétique mesurée $S_m$ de cet objet, où l'indice « i » est un identifiant du magnétomètre,
- **caractérisé par** une unité de traitement programmée pour :

• calculer un écart E entre la signature magnétique $S_m$ mesurée et une signature magnétique préenregistrée $S_{Ref}$ d'un objet magnétique connu, et
• comparer l'écart E calculé à un seuil prédéterminé et reconnaître l'objet magnétique si l'écart E est inférieur ou égal à ce seuil prédéterminé, et sinon, ne pas reconnaître l'objet magnétique.

**10.** Appareil selon la revendication 9, dans lequel l'appareil comporte un dispositif (26) de maintien de l'objet magnétique dans une position prédéterminée, ce dispositif étant au moins apte à indiquer à un être humain la position prédéterminée dans laquelle doit être placé l'objet magnétique à reconnaître.

**Patentansprüche**

**1.** Verfahren zur automatischen Erkennung eines magnetischen Objekts, umfassend:

a) das Unbeweglichhalten (102) des magnetischen Objekts vor einem Gitter aus Magnetometern mit N Drei-Achsen-Magnetometern ($M_{ij}$), die ohne irgendeinen Freiheitsgrad mechanisch miteinander verbunden sind, um einen festen Abstand zwischen jedem dieser Magnetometer zu bewahren, wobei N eine ganze Zahl größer oder gleich fünf ist, wobei der feste Abstand zwischen zwei unmittelbar aufeinander folgenden Magnetometern mindestens kleiner als die größte Entfernung zwischen den am weitesten voneinander entfernten magnetischen Teilen des magnetischen Objekts ist,
b) wenn das magnetische Objekt unbeweglich vor dem Gitter aus Magnetometern gehalten wird, das Messen (104), durch jedes Magnetometer, eines Vektors $b_{i,m}$, von dem jede Koordinate den Wert des auf eine jeweilige Messachse des Magnetometers projizierten Magnetfeldes repräsentiert, wobei eine Vereinigung von Vektoren $b_{i,m}$, die von den Magnetometern des Gitters gleichzeitig gemessen werden, eine gemessene magnetische Signatur $S_m$ dieses Objekts bildet, wobei der Index "i" eine Kennung des Magnetometers ist, **gekennzeichnet durch**
c) das Berechnen (108) einer Abweichung E zwischen der beim Schritt b) gemessenen magnetischen Signatur $S_m$ und einer vorgespeicherten magnetischen Signatur $S_{Ref}$ eines bekannten magnetischen Objekts,
d) das Vergleichen (110) der beim Schritt c) berechneten Abweichung E mit einer vorbestimmten Schwelle und das Erkennen (112) des magnetischen Objekts, wenn die Abweichung E kleiner oder gleich dieser vorbestimmten Schwelle ist, und ansonsten das Nichterkennen des magnetischen Objekts.

**2.** Verfahren nach Anspruch 1, bei dem beim Schritt a) für mindestens vier Magnetometer des Gitters aus Magnetometern der kürzeste Abstand zwischen diesen Magnetometern und dem magnetischen Objekt kleiner als $d_{max}$ ist, wobei $d_{max}$ gleich $[\mu_0 m/4\pi\sigma 10^{(SNR/20)}]^{1/3}$ ist, worin

- $\sigma$ die Standardabweichung des Rauschens des Magnetometers ist,
- $\mu_0$ die Permeabilität des Vakuums ist,
- m das magnetische Moment des magnetischen Objekts ist und
- SNR eine Konstante gleich 6,02 db ist.

**3.** Verfahren nach Anspruch 1, bei dem beim Schritt a) bei mindestens vier Magnetometern des Gitters aus Magnetometern der kürzeste Abstand zwischen diesen Magnetometern und dem magnetischen Objekt kleiner als 50 cm ist.

**4.** Verfahren nach einem der vorhergehenden Ansprüche, bei dem:

- das Verfahren die Zuordnung (108) derselben Koordinaten $a_i$, $b_i$, $c_i$ der Position des Magnetometers "i" in einem ohne irgendeinen Freiheitsgrad am Gitter aus Magnetometern fixierten Koordinatensystem XYZ zu jedem Vektor $b_{i,m}$ und zu jedem Vektor $b_{i,Ref}$ der vorgespeicherten magnetischen Signatur umfasst, wobei der Vektor $b_{i,Ref}$ dem Vektor entspricht, der beim Schritt b) vom Magnetometer i gemessen würde, wenn das bekannte Objekt in der vorbestimmten Position vor dem Gitter aus Magnetometern unbeweglich gehalten wird, und
- der Schritt c) die Transformation der einen der magnetischen Signaturen, die unter den gemessenen $S_m$ und vorgespeicherten $S_{Ref}$ magnetischen Signaturen gewählt ist, durch Translationen und/oder Rotationen, die auf die jedem der Vektoren $b_{i,m}$ oder $b_{i,Ref}$ dieser Signatur zugeordneten Koordinaten $a_i$, $b_i$, $c_i$ angewandt werden,

umfasst, um eine transformierte magnetische Signatur $S_t$ zu erhalten, welche die Abweichung zwischen dieser Signatur St und der anderen der magnetischen Signaturen, die unter den gemessenen $S_m$ und vorgespeicherten $S_{Ref}$ magnetischen Signaturen gewählt ist, minimiert, wobei der nach dem Schritt c) berechnete Wert der Abweichung E gleich dem kleinsten Wert genommen wird, der erhalten wird, nachdem diese Transformation auf die magnetische Signatur $S_m$ oder $S_{ref}$ angewandt wurde.

5. Verfahren nach einem der Ansprüche 1 bis 3, bei dem beim Schritt c) die Abweichung E ausgehend von der Differenz, für jedes Magnetometer, zwischen den Koordinaten des Vektors $b_{i,m}$ und den Koordinaten eines Vektors $b_{i,Ref}$ der vorgespeicherten magnetischen Signatur berechnet wird, wobei der Vektor $b_{i,Ref}$ dem Vektor entspricht, der bei Schritt b) vom Magnetometer i gemessen würde, wenn dieses bekannte Objekt in der vorbestimmten Position vor dem Gitter aus Magnetometern unbeweglich gehalten wird.

6. Verfahren nach einem der vorhergehenden Ansprüche, bei dem beim Schritt a) das magnetische Objekt in der vorbestimmten Position vor einem Gitter aus Magnetometern gehalten (102) wird, in dem der feste Abstand zwischen zwei unmittelbar aufeinander folgenden Magnetometern mindestens zwei Mal kleiner als die größte Entfernung zwischen den beiden am weitesten voneinander entfernten magnetischen Teilen des magnetischen Objekts ist.

7. Verfahren nach einem der vorhergehenden Ansprüche, bei dem das Gitter aus Magnetometern Magnetometer umfasst, die entlang von mindestens zwei nicht parallelen Richtungen verteilt sind.

8. Datenspeichermedium, **dadurch gekennzeichnet, dass** es Anweisungen umfasst, um die Schritte c) und d) eines Erkennungsverfahrens nach einem der vorhergehenden Ansprüche auszuführen, wenn diese Anweisungen von einem elektronischen Rechner abgearbeitet werden.

9. Gerät zur Erkennung eines magnetischen Objekts, wobei dieses Gerät umfasst:

- ein Gitter aus Magnetometern mit N Drei-Achsen-Manometern ($M_{ij}$), die ohne irgendeinen Freiheitsgrad mechanisch miteinander verbunden sind, um einen festen Abstand zwischen jedem diese Magnetometer zu bewahren, wobei N eine ganze Zahl größer oder gleich fünf ist, wobei jedes Magnetometer geeignet ist, einen Vektor $b_{i,m}$ zu messen, von dem jede Koordinate den Wert des auf eine jeweilige Messachse des Magnetometers projizierten Magnetfeldes repräsentiert, wobei eine Vereinigung von Vektoren $b_{i,m}$, die von den Magnetometern des Gitters gleichzeitig gemessen werden, eine gemessene magnetische Signatur $S_m$ dieses Objekts bildet, wobei "i" eine Kennung des Magnetometers ist,
- **gekennzeichnet durch** eine Verarbeitungseinheit, die programmiert ist, um:

• eine Abweichung E zwischen der gemessenen magnetischen Signatur $S_m$ und einer vorgespeicherten magnetischen Signatur $S_{Ref}$ eines bekannten magnetischen Objekts zu berechnen und
• die berechnete Abweichung E mit einer vorbestimmten Schwelle zu vergleichen und das magnetische Objekt zu erkennen, wenn die Abweichung E kleiner oder gleich dieser vorbestimmten Schwelle ist, und das magnetische Objekt ansonsten nicht zu erkennen.

10. Gerät nach Anspruch 9, wobei das Gerät eine Vorrichtung (26) zum Halten des magnetischen Objekts in einer vorbestimmten Position umfasst, wobei diese Vorrichtung mindestens geeignet ist, einem Menschen die vorbestimmte Position anzugeben, in der das zu erkennende magnetische Objekt platziert werden muss.

## Claims

1. Method for automatically recognizing a magnetic object, comprising:

a) the holding (102) of the magnetic object immobile in front of an array of magnetometers comprising N triaxial magnetometers ($M_{ij}$) linked mechanically to one another with no degree of freedom to maintain a fixed distance between each of these magnetometers, where N is an integer number greater than or equal to five, the fixed distance between two immediately consecutive magnetometers being at least less than the maximum separation between the magnetic parts of the magnetic object furthest away from one another,
b) when the magnetic object is held immobile in front of the array of magnetometers, the measurement (104) by each magnetometer of a vector $b_{i,m}$ of which each coordinate represents the value of the magnetic field projected onto a respective measurement axis of the magnetometer, a union of vectors $b_{i,m}$ measured at the same time by the magnetometers of the array forming a measured magnetic signature $S_m$ of this object, where the index "i" is an identifier of the magnetometer,

**characterized by**

c) the computation (108) of a deviation E between the magnetic signature $S_m$ measured in the step b) and a prerecorded magnetic signature $S_{Ref}$ of a known magnetic object,

d) the comparison (110) of the deviation E computed in the step c) to a predetermined threshold and the recognition (112) of the magnetic object if the deviation E is less than or equal to this predetermined threshold, and, if not, the absence of recognition of this magnetic object.

2. Method according to Claim 1, in which, in the step a), for at least four magnetometers of the array of magnetometers, the shortest distance between these magnetometers and the magnetic object is less than $d_{max}$, $d_{max}$ being equal to $[\mu_0 m/4\pi\sigma 10^{(SNR/20)}]^{1/3}$, where:

- $\sigma$ is the standard deviation of the noise of the magnetometer,
- $\mu_0$ is the permeability of the vacuum,
- m is the magnetic moment of the magnetic object, and
- SNR is a constant equal to 6.02 db.

3. Method according to Claim 1, in which, in the step a), for at least four magnetometers of the array of magnetometers, the shortest distance between these magnetometers and the magnetic object is less than 50 cm.

4. Method according to any one of the preceding claims, in which:

- the method comprises the association (108) with each vector $b_{i,m}$ and with each vector $b_{i,Ref}$ of the prerecorded magnetic signature, of the same coordinates $a_i$, $b_i$, $c_i$ of the position of the magnetometer "i" in a reference frame XYZ fixed with no degree of freedom to the array of magnetometers, the vector $b_{i,Ref}$ corresponding to the vector which would be measured in the step b), by the magnetometer i, when the known object is held immobile in the predetermined position in front of the array of magnetometers, and

- the step c) includes the transformation of one of the magnetic signatures chosen from the measured $S_m$ and prerecorded $S_{Ref}$ magnetic signatures by translations and/or rotations applied to the coordinates $a_i$, $b_i$, $c_i$ associated with each of the vectors $b_{i,m}$ or $b_{i,Ref}$ of this signature, to obtain a transformed magnetic signature $S_t$ which minimizes the deviation between this signature $S_t$ and the other of the magnetic signatures chosen from the measured $S_m$ and prerecorded $S_{Ref}$ magnetic signatures, the value of the deviation E computed at the end of the step c) being taken to be equal to the minimum value obtained after having applied this transformation to the magnetic signature $S_m$ or $S_{ref}$.

5. Method according to any one of Claims 1 to 3, in which, in the step c), the deviation E is computed from the difference, for each magnetometer, between the coordinates of the vector $b_{i,m}$ and coordinates of a vector $b_{i,Ref}$ of the prerecorded magnetic signature, the vector $b_{i,Ref}$ corresponding to the vector which would be measured in the step b), by the magnetometer i, when this known object is held immobile in the predetermined position in front of the array of magnetometers.

6. Method according to any one of the preceding claims, in which, in the step a), the magnetic object is held (102) in the predetermined position in front of an array of magnetometers in which the fixed distance between two immediately consecutive magnetometers is at least two times smaller than the maximum separation between the two magnetic parts of the magnetic object furthest away from one another.

7. Method according to any one of the preceding claims, in which the array of magnetometers comprises magnetometers distributed along at least two non-parallel directions.

8. Information storage medium, **characterized in that** it comprises instructions for carrying out the steps c) and d) of a recognition method according to any one of the preceding claims, when these instructions are executed by an electronic computer.

9. Apparatus for recognizing a magnetic object, this apparatus comprising:

- an array of magnetometers comprising N tri-axial magnetometers ($M_{ij}$) linked mechanically to one another with no degree of freedom to maintain a fixed distance between each of these magnetometers, where N is an integer number greater than or equal to five, each magnetometer being suitable for measuring a vector $b_{i,m}$ of which each coordinate represents the value of the magnetic field projected onto a respective measurement axis of the magnetometer, a union of vectors $b_{i,m}$ measured at the same time by the magnetometers of the array forming a measured magnetic signature $S_m$ of this object, where the index "i" is an identifier of the magnetometer,

**characterized by** a processing unit programmed to:

• compute a deviation E between the measured magnetic signature $S_m$ and a prerecorded magnetic signature $S_{Ref}$ of a known magnetic object, and
• comparing the computed deviation E to a predetermined threshold and recognizing the magnetic object if the deviation E is less than or equal to this predetermined threshold, and if not, not recognizing the magnetic object.

10. Apparatus according to Claim 9, in which the apparatus comprises a device (26) for holding the magnetic object in a predetermined position, this device being at least suitable for indicating to a human being the predetermined position in which the magnetic object to be recognized must be placed.

Fig. 1

Fig. 2

40    44

36

Fig. 3

70

72

74

76

78

100

102

104

106

108

−  110  +

112

Fig. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6841994 B1

- FR 2952450 A1